(19) Europäisches Patentamt
European Patent Office
Office européen des brevets

(11) **EP 0 836 085 B1**

(12) **EUROPÄISCHE PATENTSCHRIFT**

(45) Veröffentlichungstag und Bekanntmachung des Hinweises auf die Patenterteilung:
**29.01.2003 Patentblatt 2003/05**

(51) Int Cl.7: **G01K 7/20**

(21) Anmeldenummer: **97114769.9**

(22) Anmeldetag: **26.08.1997**

(54) **Widerstandsmessschaltung und Widerstandsmessverfahren**

Resistance measuring circuit and resistance measuring method

Circuit de mesure de résistance et méthode de mesure de résistance

(84) Benannte Vertragsstaaten:
**AT BE CH DE DK ES FR GB GR IT LI LU NL SE**
Benannte Erstreckungsstaaten:
**SI**

(30) Priorität: **09.10.1996 DE 19641648**

(43) Veröffentlichungstag der Anmeldung:
**15.04.1998 Patentblatt 1998/16**

(73) Patentinhaber: **Ziegler, Horst Prof. Dr.**
**D-33100 Paderborn (DE)**

(72) Erfinder: **Ziegler, Horst Prof. Dr.**
**D-33100 Paderborn (DE)**

(74) Vertreter: **Tiesmeyer, Johannes, Dr. et al**
**Weickmann & Weickmann**
**Patentanwälte**
**Postfach 86 08 20**
**81635 München (DE)**

(56) Entgegenhaltungen:
**JP-A- 61 223 622        US-A- 5 371 469**

• **H.R. TAYLOR E.A.: "A MICROCOMPUTER-BASED INSTRUMENT FOR APPLICATIONS IN PLATINUM RESISTANCE THERMOMETRY" JOURNAL OF PHYSICS E. SCIENTIFIC INSTRUMENTS., Bd. 16, Nr. 11, November 1983, BRISTOL GB, Seiten 1100-1104, XP002051710**

## Beschreibung

Die Erfindung betrifft eine Widerstandsmeßschaltung, die zur Messung des Widerstandes eines resistiven Sensorwiderstandselementes einsetzbar ist und die Meßergebnisse in digitalisierter Form bereitstellt.

Im meßtechnischen Bereich werden häufig Widerstandssensoren eingesetzt, um physikalische Größen zu erfassen. Als Beispiel sei die Temperaturmessung mit einem Temperaturmeßwiderstand genannt, dessen Widerstandswert von der Temperatur abhängt. Temperaturmeßwiderstände werden als Halbleiterfühler und als metallische Fühler angeboten. Die als NTC-Widerstände und als PTC-Widerstände bekannten Halbleiterfühler zeichnen sich durch hohe Empfindlichkeit und durch schnelle Reaktion auf Temperaturänderungen aus. Metallische Fühler in Form von Platinwiderstands-Temperaturfühlern oder Nickelwiderstands-Temperaturfühlern haben demgegenüber den Vorteil der besseren Langzeitkonstanz, der besseren Reproduzierbarkeit sowie der besseren Linearität. Die aufgrund dieser Vorteile und wegen ihrer Robustheit in der Prozeßmeßtechnik häufig bevorzugten Platinwiderstands-Temperaturfühler werden als Standard-Bauelemente mit den Bezeichnungen PT 100 mit einem Nennwiderstand von 100 $\Omega$ bei 0°C, PT 500 mit einem Nennwiderstand von 500 $\Omega$ bei 0°C und PT 1000 mit einem Nennwiderstand von 1000 $\Omega$ bei 0°C angeboten und weisen einen Temperaturkoeffizienten von etwa 0,39 %/ K auf.

In Meßsituationen mit sehr hohen Anforderungen an die Auflösung der Widerstands- bzw. Temperaturmessung erforderte der Einsatz von relativ preiswerten, jedoch in ihrer Empfindlichkeit begrenzten PT 100-Platinwiderstands-Temperaturfühlern bisher aufwendige Widerstandsmeßschaltungen. Für die Bereitstellung der Meßergebnisse in digitaler Form zur Weiterverarbeitung durch Mikroprozessoren sind derartige Meßschaltungen üblicherweise mit Analog/Digital-Wandlern entsprechender Auflösung ausgestattet. Bei diesen Analog/Digital-Wandlern kann es sich um integrierte Halbleiterbausteine handeln. Integrierte A/D-Wandler hoher Auflösung sind jedoch teuer und haben einen vergleichsweise großen Strombedarf, so ciaß sie für den Einsatz in Meßschaltungen mit einer Batterie als Betriebsspannungsquelle ungeeignet sind. Häufig werden A/D-Wandlerschaltungen nach dem Dual-slope-Verfahren eingesetzt, um eine hochauflösende Analog/Digital-Wandlung vorzunehmen. Derartige A/D-Wandlerschaltungen benötigen eine oder mehrere Konstantstromquellen bzw. Operationsverstärker zur Erzeugung linearer Rampenspannungsverläufe und ferner mehrere Versorgungsspannungen.

Ein vergleichsweise einfaches Widerstandsmeßverfahren mit A/D-Wandlung stellt das sogenannte Widerstands-Zeit-Wandlungsverfahren dar, das mit einer vergleichsweise einfachen Schaltung durchgeführt werden kann. Die Widerstandsmessung nach dem konventionellen Widerstands-Zeit-Wandlungsverfahren ist beispielsweise in der Beschreibungseinleitung der DE 44 20 998 A1 beschrieben und wird nachstehend unter Bezugnahme auf Fig. 3 kurz erläutert.

Ein Kondensator 100 mit der Kapazität C wird in einem ersten Schritt über einen Referenzwiderstand $R_1$ auf die von der Batterie 102 bereitgestellte Betriebsspannung $U_B$ aufgeladen. In einem zweiten Schritt wird der Kondensator 100 über den Referenzwiderstand $R_1$ nach entsprechender Umschaltung des Schalters 104 von A nach C nach Masse entladen. Ein Zeitzähler 106 wird dazu eingesetzt, die Zeit $t_1$ vom Beginn der Entladung des Kondensators 100 bis zu dem Zeitpunkt zu messen, in dem die Kondensatorspannung U auf einen vorbestimmten Referenzspannungswert abgesunken ist. Zur Überwachung des Entladevorgangs ist ein Analogkomparator 108 vorgesehen, dessen Referenzspannungseingang mit dem Abgriffspunkt eines die vorbestimmte Referenzspannung bereitstellenden Spannungsteilers 110 verbunden ist und dessen Spannungsüberwachungseingangsanschluß mit dem Kondensator verbunden ist. Das Ausgangssignal des Komparators 108 startet und stoppt den Zählbetrieb des Zeitzählers 106.

In einem dritten Schritt wird der Kondensator 100 erneut über den Widerstand $R_1$ auf die Batteriespannung $U_B$ aufgeladen, wonach in einem vierten Schritt die Entladung des Kondensators 100 über den Meßwiderstand Rx bei entsprechender Einstellung der Schalter 104 und 112 nach Masse folgt. Der Zeitzähler 106 bestimmt die Zeit tx zwischen dem Beginn dieser letzteren Entladephase und dem Zeitpunkt, in dem die Kondensatorspannung die vorbestimmte Referenzspannung unterschreitet.

Der Wert Rx des Widerstandes Rx hängt bei Vernachlässigung der Bahnwiderstände der Analogschalter 104 und 112 gemäß nachstehender Beziehung von den gemessenen Entladezeiten tx und $t_1$ sowie dem Wert des Referenzwiderstandes $R_1$ ab.

$$Rx = R_1 \cdot \frac{tx}{t_1}$$

Die den Entladezeiten tx, $t_1$ entsprechenden Zählergebnisse des Zeitzählers liegen in digitaler Form vor und können von einer Rechenschaltung zur Bestimmung des Widerstandswertes Rx gemäß der vorstehend genannten Beziehung übernommen werden.

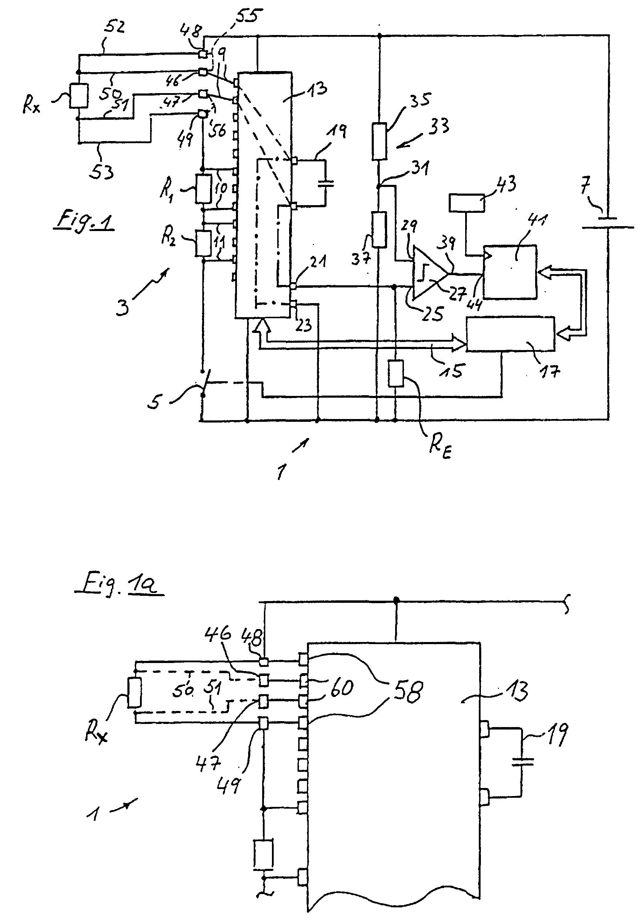

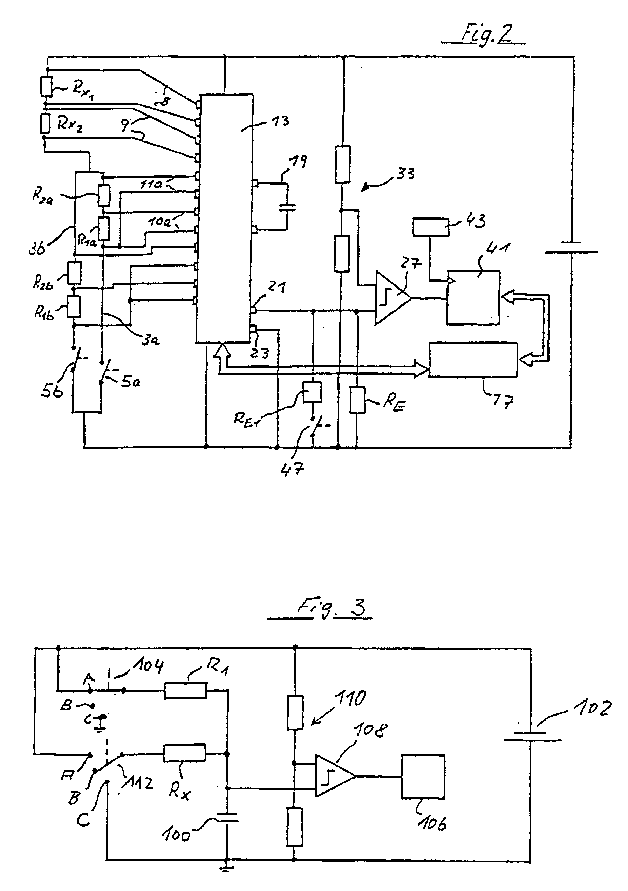

Bei dem Widerstands-Zeit-Wandlungsverfahren werden jedoch unvermeidlich die Bahnwiderstände der Schalter 104, 112 zur Aktivierung der verschiedenen alternativen Entladungspfade mitgemessen. Sind beispielsweise größere Anforderungen an die Genauigkeit bei der Messung von Widerstandsänderungen eines Platin-Temperaturmeßwiderstandes Rx gestellt, so müssen die Bahnwiderstände der Schalter 104, 112 im Vergleich zur Widerstandsänderung des Temperatur-Meßeffektes verschwindend klein, mindestens aber bis auf wenige mΩ gleich sein, was nur schwierig zu realisieren ist. Bei Temperaturmessungen mit hochohmigen NTC- oder PTC-Widerständen mit großen Temperaturkoeffizienten und mit Widerstandswerten in der Größenordnung von 10 kΩ können die Einflüsse der Schaltungswiderstände im allgemeinen toleriert werden. Bei Einsatz von fertigungstechnisch bedingt stets niederohmigen Platinwiderstands-Temperaturfühlern als Meßwiderstände bereiten die Bahnwiderstände der Schalter 104, 112 bei der bekannten Schaltung nach Fig. 3 jedoch Probleme.

In der DE 44 20 998 A1 wird ergänzend eine dritte Entladung des betreffenden Kondensators über einen weiteren Referenzwiderstand und eine entsprechende Zeitzählung bis zum Unterschreiten der Referenzspannung des Komparators vorgeschlagen, um die Schalterwiderstände bei der Auswertung der Meßergebnisse der jeweils drei Entladeschritte zu eliminieren, wobei vorausgesetzt wird, daß die betreffenden Schalterwiderstände gleich groß sind. Das in der DE 44 20 998 A1 beschriebene Meßverfahren eignet sich beispielsweise zur Temperaturmessung mit einem NTC-Widerstand, etwa bei einem elektrischen Heizkostenverteiler.

Die Auflösung der Widerstandsmessung hängt bei gegebener Auflösung der Zeitzählung von den Entladezeitkonstanten bei der Entladung des Kondensators 100 ab. Soll die Zeitzählung beispielsweise mit einer Auflösung von ca. 1 µs erfolgen, wie dies mit üblichen Mikroprozessor-Timern möglich ist, so sollten die Entladezeiten zur Erzielung einer hinreichend hohen Widerstandsmeßauflösung bei Einsatz von Temperaturmeßwiderständen mindestens 10 ms betragen.

Bei Einsatz eines niederohmigen Platinwiderstands-Temperaturfühlers als Meßwiderstand Rx in einer Schaltung gemäß Fig. 3 stellt sich das Problem, daß zur Realisierung einer entsprechend großen Zeitkonstanten bei der Entladung über den Meßwiderstand Rx der Ladekondensator 100 eine Kapazität in der Größenordnung von 10 - 100 µF aufweisen muß. Solche Kondensatoren sind realistisch nur als Tantal- oder Elektrolyt-Kondensatoren verfügbar. Deren erhebliche Leckströme und Memory-Effekte verhindern brauchbare Messungen. Hinzu kommt, daß derartige Kondensatoren bei mehrmaliger Aufladung die Batterie stark belasten.

Ein weiterer Nachteil des konventionellen Widerstands-Zeit-Wandlungsverfahrens mit einer Schaltung gemäß Fig. 3 besteht darin, daß der Meßwiderstand Rx nicht in Vierleiter-Schaltungskonfiguration zur Eliminierung des Einflusses des Widerstandes der Zuleitungen angeschlossen werden kann. Dies schränkt ebenfalls die Möglichkeit des Einsatzes niederohmiger Platinwiderstands-Temperaturfühler ein, insbesondere wenn lange Zuleitungen zu einem entfernten Meßort erforderlich sind. Die Zuleitungen zu einem externen Fühler Rx können überdies Fremdspannungsstörungen ausgesetzt sein. Diese schlagen direkt auf den Umschaltzeitpunkt des Komparators und damit auf die Zeitmessung durch, wodurch das Meßergebnis verfälscht werden kann.

Aus der DE 23 12 858 C2 ist ein Verfahren und eine Schaltung zur Widerstandsdifferenzmessung zweier Temperaturmeßwiderstände bekannt, wobei die Widerstandsdifferenzmessung bei der elektronischen Wärmemengenmessung angewandt wird. Die aus der DE 23 12 858 C2 bekannte Widerstandsmeßschaltung weist eine Reihenschaltung aus den beiden Temperaturmeßwiderständen und zwei untereinander gleich großen Referenzwiderständen auf, die in der Reihenschaltung zwischen den beiden Temperaturmeßwiderständen liegen, wobei zwischen den beiden Referenzwiderständen ein Anschluß zu einem Bezugspotential hin vorgesehen ist. Die Reihenschaltung ist an ihren äußeren Anschlüssen über eine Polwechselschaltung mit einer Gleichspannungsquelle verbunden. Die Spannungen an den äußeren Enden der Reihenschaltung liegen über Pufferverstärker und Summierwiderstände an einem Eingang eines Integrators an, der einen Integrationskondensator aufweist. Der Ausgang des Integrators ist mit dem Eingang eines Komparators verbunden, dessen Referenzspannung an einer Stelle der Reihenschaltung zwischen einem der Meßwiderstände und dem benachbarten Referenzwiderstand abgegriffen wird. Der Ausgang des Komparators ist mit einer Steuerschaltung zur Steuerung der Polwechselschaltung verbunden. Erreicht die Ausgangsspannung des Integrators die Referenzspannung des Komparators, so gibt der Komparator ein Signal an die Steuerschaltung ab, die die Polwechselschaltung umschaltet, so daß die Gleichspannungsquelle mit umgekehrter Polarität an der Reihenschaltung angeschlossen ist. Dabei kehren sich alle Spannungen an den Widerständen und auch die Richtung des Ladestroms an dem Integrator um. Die Ausgangsspannung des Integrators läuft nunmehr zeitlich in Richtung auf die ebenfalls gegenüber der ersten Ladephase des Integrationskondensators umgekehrte Referenzspannung des Komparators, bis diese erreicht wird. Daraufhin erfolgt wieder ein Polwechsel an den äußeren Anschlüssen der Reihenschaltung. Die Schaltung nach der DE 23 12 858 C2 stellt somit einen Oszillator dar, dessen Frequenz (Frequenz der Aufund Abladungen des Integrationskondensators) der Differenz der Temperaturmeßwiderstände proportional ist. Mit einem am Ausgang des Komparators angeschlossenen Frequenzzähler wird die Frequenz gemessen. Das Meßergebnis fließt in die Auswertung einer Wärmemengenmessung ein.

Der Erfindung liegt die Aufgabe zugrunde, eine Widerstandsmeßschaltung bereitzustellen, die mit geringem Schaltungsaufwand preisgünstig realisierbar ist, die eine geringe Störanfälligkeit aufweist und die ferner eine hochauflösende Erfassung von Widerstandsänderungen auch niederohmiger Meßwiderstände ermöglicht und insbesondere stromsparend betrieben werden kann.

Zur Lösung dieser Aufgabe umfaßt die Widerstandsmeßschaltung nach der Erfindung eine an Gleichspannung einer Gleichspannungsquelle anzuschließende Reihenschaltung aus wenigstens zwei Referenzwiderstandseinheiten und wenigstens einem Meßwiderstand, wobei jede der Referenzwiderstandseinheiten und jeder Meßwiderstand über ein jeweiliges von der Reihenschaltung abzweigendes Leiterpaar mit einer Analog-Multiplexerschaltung elektrisch verbunden ist, die unter Kontrolle einer Steuer- und Auswerteschaltung

a) wechselweise jedes der Leiterpaare mit einem Kondensator elektrisch verbindet, um den Kondensator jeweils bis zum Erreichen des Gleichgewichts-Ladezustandes auf eine den Spannungsabfall an der betreffenden Referenzwiderstandseinheit bzw. an dem betreffenden Meßwiderstand repräsentierende Ladespannung aufzuladen, und
b) die nach jeweiliger Aufladung des Kondensators den Kondensator von dem betreffenden Leiterpaar elektrisch trennt und mit einer einen Entladewiderstand enthaltenden Kondensatorladeschaltung verbindet, um den Kondensator über den Entladewiderstand zu entladen, wobei die Kondensatorentladeschaltung mit einer digitalen Zeitmeßschaltung verbunden ist, die die Entladezeit vom Beginn der jeweiligen Entladephase bis zum Abfall der Kondensatorspannung auf einen vorbestimmten Wert erfaßt und als digitale Information zur Speicherung und weiteren Auswertung durch die Steuer- und Auswerteschaltung bereitstellt, und wobei die Steuer- und Auswerteschaltung auf der Basis wenigstens dreier Entladezeitmeßwerte, die den Entladungen des Kondensators aus den Ladezuständen entsprechend den jeweiligen Spannungsabfällen an den einzelnen Referenzwiderstandseinheiten und an einem betreffenden Meßwiderstand zugeordnet sind, ein den Widerstandswert des betreffenden Meßwiderstandes repräsentierendes oder ggf. von dem Widerstandswert abhängiges Meßergebnis berechnet.

Die erfindungsgemäße Widerstandsmeßschaltung kann mit preiswert verfügbaren Bauelementen realisiert werden.

Da der Kondensator stets über denselben Entladepfad entladen wird, spielen Schalterwiderstände, wie sie bei dem konventionellen Widerstands-Zeit-Wandlungsverfahren Probleme bereiten, bei der erfindungsgemäßen Widerstandsmeßschaltung keine Rolle.

Die Zeitkonstante der Kondensatorentladung hängt von der Kapazität des Kondensators und von dem Widerstandswert des Entladewiderstandes - und nicht von dem Meßwiderstand ab, so daß auch bei Messungen mit einem niederohmigen Meßwiderstand ein Kondensator mit vergleichsweise kleiner Kapazität bei entsprechender Dimensionierung des Entladewiderstandes verwendet werden kann.

Besondere Vorteile ergeben sich daraus, daß während der Kondensatorentladephasen die ggf. langen und Fremdspannungsstörungen ausgesetzten Zuleitungen des Meßwiderstandes vom Entladepfad des Kondensators und der daran angeschlossenen Zeitmeßschaltung isoliert sind. Störspannungs-Einstreuungen werden daher nicht von den Zuleitungen des Meßwiderstandes auf den Entladepfad des Kondensators übertragen. Während der jeweiligen Ladephasen des Kondensators mittelt der Kondensator sehr gut über Störspannungs-Einstreuungen aus.

Ein weiterer Vorteil besteht darin, daß die Steilheit des Spannungsverlaufs bei der Entladung des Kondensators im Zeitpunkt des Unterschreitens des vorbestimmten Spannungsreferenzwertes unabhängig vom Wert des jeweiligen Meßwiderstandes ist, was die genaue Erfassung dieses Zeitpunktes erleichtert.

Die erfindungsgemäße Widerstandsmeßschaltung sieht ferner Vierleiter-Anschlußkonfiguration des Meßwiderstandes vor, wodurch Meßunsicherheiten aufgrund der Zuleitungswiderstände weitestgehend unterdrückt werden.

Bei Bedarf ist andererseits auch Meßbetrieb bei Zweileiter-Schaltungskonfiguration des Meßwiderstandes möglich.

Der Wert Rx des Meßwiderstandes hängt von den gemessenen Entladezeiten gemäß der folgenden Beziehung ab:

$$Rx = R_1 \cdot \exp\left(\frac{tx-t_1}{t_2-t_1} \cdot \ln \frac{R_2}{R_1}\right) \qquad (1)$$

Darin bezeichnet tx die gemessene Entladezeit bei der Entladung des Kondensators aus dem Ladezustand mit der Ladespannung entsprechend dem Spannungsabfall an dem Meßwiderstand,

$t_1$ die gemessene Entladezeit bei Entladung des Kondensators aus dem Ladezustand mit der Ladespannung entsprechend dem Spannungsabfall an der ersten Referenzwiderstandseinheit,

$t_2$ die gemessene Entladezeit bei Entladung des Kondensators aus dem Ladezustand mit der Ladespannung entsprechend dem Spannungsabfall an der zweiten Referenzwiderstandseinheit,

$R_1$ den Widerstandswert der ersten Referenzwiderstandseinheit und

$R_2$ den Widerstandswert der zweiten Referenzwiderstandseinheit.

Die Steuer- und Auswerteschaltung berechnet den Widerstandswert Rx nach einem Algorithmus auf der Grundlage der vorstehend angegebenen Beziehung.

Es können mehrere Meßwiderstände in Reihe zueinander und zu den Referenzwiderstandseinheiten in der Reihenschaltung vorgesehen sein und zur Messung ihres Widerstandswertes in den Meßprozeß einbezogen werden.

Die vorstehend genannte Beziehung für die Berechnung des betreffenden Widerstandswertes behält dabei ihre Gültigkeit, wenn Rx den Widerstandswert des jeweils betrachteten Meßwiderstandes und tx die Entladezeit des Kondensators nach Aufladung auf den Spannungsabfall an dem betreffenden Widerstand angibt.

Die erfindungsgemäße Widerstandsmeßschaltung eignet sich daher auch zur Messung von Widerstandsdifferenzen und Widerstandsverhältnissen. Handelt es sich bei den Meßwiderständen um resistive Temperatursensoren, so können entsprechend Temperaturdifferenzen und Temperaturverhältnisse in jedem Meßzyklus ermittelt werden.

Gemäß einer Weiterbildung der erfindungsgemäßen Widerstandsmeßschaltung ist ein elektronischer Schalter in der Reihenschaltung aus den Referenzwiderstandseinheiten und dem Meßwiderstand vorgesehen, wobei dieser Schalter von der Steuer- und Auswerteschaltung derart geschaltet ist, daß er den Stromfluß durch die Reihenschaltung während der Entladephasen des Kondensators unterbricht. Diese Lösung hat den Vorteil, daß während der im Vergleich mit den Ladephasen langen Entladephasen des Kondensators kein Strom durch die Reihenschaltung fließt, was den Strombedarf insgesamt reduziert und bei Anschluß einer Batterie als Betriebsspannungsquelle deren Lebensdauer erhöht.

Zur einfachen Erfassung der jeweiligen Entladezeiten wird vorgeschlagen, daß ein mit dem Entladewidestand verbundener Komparator vorgesehen ist, der die Kondensatorspannung mit einer dem vorbestimmten Wert entsprechenden Referenzspannung vergleicht und der ein Stoppsignal an die Zeitmeßschaltung abgibt, wenn die Kondensatorspannung den vorbestimmten Wert unterschreitet, wobei die Zeitmeßschaltung einen Taktimpulse einer Taktimpulsquelle zählenden Zähler aufweist, dessen Zählbetrieb durch ein Startsignal synchron mit Beginn einer jeweiligen Kondensatorentladephase gestartet - und durch das Stoppsignal des Komparators gestoppt wird, so daß das jeweilige Zählergebnis des Zählers einen auf die Periodendauer des Taktimpulssignals der Taktimpulsquelle normierten Entladezeitmeßwert repräsentiert.

Die Kondensatorentladeschaltung ist vorzugsweise so ausgebildet, daß einer der Anschlüsse des Kondensators während der Entladephasen unmittelbar an Massepotential liegt und der andere Anschluß des Kondensators mit einem ersten Eingang des Komparators - und ferner über den Entladewiderstand mit Masse-Potential verbunden ist.

Zur Bereitstellung der Referenzspannung des Komparators wird ein Spannungsteiler vorgeschlagen, der parallel zu der Reihenschaltung aus den Referenzwiderstandseinheiten und dem Meßwiderstand bzw. den Meßwiderständen an der Gleichspannungsquelle angeschlossen ist und dessen Spannungsteilerabgriffspunkt mit einem zweiten Eingang des Komparators verbunden ist. Hierdurch wird mit einfachen Mitteln erreicht, daß die Komparatorschwelle ein fester Bruchteil der an der Reihenschaltung aus Meß- und Referenzwiderständen anliegenden Betriebsspannung ist, wodurch der Einfluß der Betriebsspannung auf die Meßergebnisse eliminiert wird.

Die Steuer- und Auswerteschaltung kann auf einfache Weise unter Einbeziehung eines Mikroprozessors realisiert werden, wobei ein Timer des Mikroprozessors für die Zeitmessung herangezogen werden kann.

Die Referenzwiderstandseinheiten können aus Einzelwiderständen bestehen.

Alternativ können die Referenzwiderstandseinheiten auch aus einer Zusammenschaltung mehrerer Einzelwiderstände gebildet sein.

Die erfindungsgemäße Widerstandsmeßschaltung eignet sich sehr gut zum Einsatz als Temperaturmeßschaltung, wobei der Meßwiderstand ein Temperaturmeßwiderstand, insbesondere Platinwiderstands-Temperaturfühler, ist.

Gegenstand der Erfindung ist ferner ein Widerstandsmeßverfahren gemäß Anspruch 11, welches unter Verwendung der erfindungsgemäßen Widerstandsmeßschaltung durchführbar ist.

Die Erfindung wird im folgenden unter Bezugnahme auf die Figuren näher erläutert.

Fig. 1     zeigt eine Schaltskizze eines ersten Ausführungsbeispiels einer Widerstandsmeßschaltung nach der Erfindung.

Fig. 1a     stellt eine Portial -Schaltskizze des Ausführungsbeispiels nach Fig. 1 dar und dient zur Erläuterung verschiedener Anschlußkonfigurationen des Meßwiderstandes.

Fig. 2     zeigt eine Schaltskizze eines zweiten Ausführungsbeispiels einer Widerstandsmeßschaltung nach der Erfindung.

Fig. 3     zeigt die Schaltskizze einer Widerstandsmeßschaltung, die nach dem konventionellen Widerstandszeit-Wandlungsverfahren arbeitet.

In Fig. 1 ist ein schematisches Schaltbild eines ersten Ausführungsbeispiels einer Widerstandsmeßschaltung nach der Erfindung dargestellt.

Die Widerstandsmeßschaltung 1 umfaßt in einer Reihenschaltung 3 einen Meßwiderstand Rx, einen ersten Referenzwiderstand $R_1$, einen zweiten Referenzwiderstand $R_2$ und einen Schalter 5, wobei die Reihenschaltung 3 mit ihren äußeren Anschlüssen an der Batterie 7 angeschlossen ist, die die Betriebsspannungsquelle für die gesamte Widerstandsmeßschaltung bildet.

Jeder der Widerstände Rx, $R_1$ und $R_2$ ist über ein jeweiliges Leiterpaar 9, 10, 11 mit betreffenden Eingangsanschlüssen eines steuerbaren Analog-Multiplexers 13 verbunden, der über Steuerleitungen 15 mit einer Steuer- und Auswerteschaltung 17 in Verbindung steht. Unter Kontrolle der Steuer- und Auswerteschaltung 17 kann der Analog-Multiplexer 13 wechselweise jedes der Leiterpaare 9, 10, 11 mit den Anschlüssen eines an dem Analog-Multiplexer angeschlossenen Kondensators 19 verbinden, wie dies für den Fall des Leiterpaares 9 schematisch durch gestrichelte Linien angedeutet ist. Bei einer solchen temporären Verbindung des Kondensators 19 mit dem jeweiligen Widerstand Rx, $R_1$ oder $R_2$ der Reihenschaltung 3 kommt es zur Aufladung des Kondensators 19 auf eine dem Spannungsabfall an dem betreffenden Widerstand Rx, $R_1$ bzw. $R_2$ entsprechende Ladespannung.

Der Analog-Multiplexer 13 ist von der Steuer- und Auswerteschaltung 17 ferner so ansteuerbar, daß er die Anschlüsse des Kondensators 19 mit den Ausgangsanschlüssen 21 und 23 des Analog-Multiplexers 13 verbindet, wie dies schematisch durch Strichpunktlinien in Fig. 1 angedeutet ist, wobei in dem letztgenannten Betriebszustand des Analog-Multiplexers 13 keines der Leiterpaare 9, 10 und 11 elektrisch mit dem Kondensator 19 verbunden ist.

Der Ausgangsanschluß 23 des Analog-Multiplexers 13 liegt unmittelbar an Masse, wohingegen der Ausgangsanschluß 21 mit einem Entladewiderstand $R_E$ und mit einem ersten Eingang 25 eines Spannungskomparators 27 verbunden ist. Der Entladewiderstand $R_E$ verbindet den Ausgangsanschluß 21 des Analog-Multiplexers 13 mit Masse entsprechend dem positiven Potential der Batterie 7.

Der zweite Eingang 29 des Komparators 27 ist mit dem Abgriffspunkt 31 eines Spannungsteilers 33 verbunden, der aus den Widerständen 35, 37 besteht und parallel zu der Reihenschaltung 3 der Referenzwiderstände $R_1$, $R_2$ und des Meßwiderstandes Rx an der Batterie 7 angeschlossen ist. Der Spannungsteiler 33 ist so dimensioniert, daß die an dem Abgriffspunkt 31 abgegriffene Referenzspannung für den Komparator 27 kleiner ist als der Spannungsabfall an dem kleinsten Widerstand $R_1$, $R_2$ oder Rx in der Reihenschaltung 3.

Der Komparator 27 weist an seinem Ausgang 39 H-Pegel auf, wenn die Spannung an dem ersten Komparatoreingang 25 größer ist als die Referenzspannung an dem zweiten Komparatoreingang 29. Sobald die Spannung an dem ersten Komparatoreingang 25 die Referenzspannung an dem zweiten Komparatoreingang 29 unterschreitet, schaltet der Komparator 27 seinen Ausgang 39 auf L-Pegel um. Das binäre Ausgangssignal des Komparators 27 wird zur Steuerung der Zählbereitschaft eines digitalen Zählers 41 genutzt, der Taktimpulse einer Taktimpulsquelle 43 zählt, die als Quarzoszillatorschaltung ausgebildet ist. Der Ausgang 39 des Komparators 27 ist mit dem Start/Stopp-Eingang 44 des Zählers 41 verbunden. Bei einem Übergang des Ausgangssignals des Komparators 27 von L-Pegel nach H-Pegel beginnt der Zähler 41 mit der Zählung der Taktimpulse von der Taktimpulsquelle 43. Der Zählvorgang wird gestoppt, wenn der Pegel des Ausgangssignals des Komparators 27 wieder von H nach L übergeht. Das jeweilige Zählergebnis des Zählers 41 wird zur Speicherung und weiteren Auswertung von der Steuer- und Auswerteschaltung 17 übernommen, bei der es sich um eine Mikroprozessorschaltung handelt. Es sei darauf hingewiesen, daß der Zähler 41 und die Taktimpulsquelle 43 Bestandteile einer Timer-Schaltung der Mikroprozessorschaltung 17 sein können.

Nachstehend wird die Funktionsweise der Widerstandsmeßschaltung 1 nach Fig. 1 bei der Ermittlung des Widerstandswertes des Meßwiderstands Rx erläutert.

Ein Meßzyklus beginnt damit, daß die Steuer- und Auswerteschaltung 17 ein Steuersignal über die Datenleitungen 15 an den Analog-Multiplexer 13 abgibt, welches den Analog-Multiplexer 13 dazu veranlaßt, das mit den Anschlüssen des Meßwiderstandes Rx verbundene Leiterpaar 9 mit den Anschlüssen des Kondensators 19 zu verbinden. Für den Kondensator 19 beginnt damit eine Ladephase, in der er auf eine Ladespannung entsprechend dem Spannungsabfall an dem Meßwiderstand Rx aufgeladen wird. Die Dauer der Ladephase ist so bemessen, daß sich bei der Aufladung des Kondensators 19 der Gleichgewichtszustand einstellt. Danach steuert die Steuer- und Auswerteschaltung 17 den Analog-Multiplexer 13 mit einem Steuersignal an, welches den Analog-Multiplexer 13 dazu veranlaßt, das Leiterpaar 9 von den Anschlüssen des Kondensators 19 elektrisch zu trennen und die Kondensatoranschlüsse mit den Ausgangsanschlüssen 21 und 23 des Analog-Multiplexers 13 zu verbinden. Damit ist dann eine Entladephase des Kondensators 19 eingeleitet, in der der Kondensator 19 über den Entladewiderstand $R_E$ nach Masse entladen wird. Mit Beginn der Entladephase ist der Zählbetrieb des Zählers 41 gestartet worden, da der Pegel des Ausgangssignals des Komparators 27 beim'Anlegen der Kondensatorspannung an den Eingang 25 des Komparators 27 einen Übergang von L nach H erfahren hat. Der Zählbetrieb des Zählers 41 wird wieder gestoppt, sobald die Entladung des Kondensators 19 so weit fortgeschritten ist, daß die Spannung an dem ersten Komparatoreingang 25 die Referenzspannung an dem zweiten Komparatoreingang 29 unterschreitet und der Komparator 27 daraufhin einen Pegelwechsel seines Ausgangssignals von H nach L vornimmt.

Das von der Steuer- und Auswerteschaltung 17 übernommene Zählergebnis entspricht nach Multiplikation mit der Periodendauer des Taktimpulssignals der Taktimpulsquelle 43 der Entladezeit tx des Kondensators 19 bei der Entladung aus dem Gleichgewichtsladezustand mit der Ladespannung entsprechend dem Spannungsabfall an dem Meßwiderstand Rx bis zum Abfall der Kondensatorspannung auf die an dem Spannungsteiler 33 abgegriffene Referenzspannung des Komparators 27.

In einem nächsten Schritt steuert die Steuer- und Auswerteschaltung 17 den Analog-Multiplexer 13 in der Weise an, daß der Analog-Multiplexer 13 das dem ersten Referenzwiderstand $R_1$ zugeordnete Leiterpaar 10 mit den Anschlüssen des Kondensators 19 verbindet, wodurch eine erneute Ladephase des Kondensators 19 eingeleitet wird, in der der Kondensator 19 bis zum Erreichen des Gleichgewichtsladezustandes auf eine Ladespannung entsprechend dem Spannungsabfall an dem Referenzwiderstand $R_1$ geladen wird. Nach Abschluß dieser zweiten Ladephase des Kondensators 19 veranlaßt die Steuer- und Auswerteschaltung 17 den Analog-Multiplexer 13 wieder dazu, die Anschlüsse des Kondensators 19 mit den Ausgangsanschlüssen 21 und 23 zu verbinden, um den Kondensator 19 zu entladen, wobei der Zähler 41 in der oben beschriebenen Weise in Betrieb gesetzt wird, um nun die Entladezeit $t_1$ vom Beginn der zweiten Entladephase bis zu dem Zeitpunkt zu erfassen, in dem die Kondensatorspannung die Referenzspannung des Komparators 27 unterschreitet.

In einem weiteren Schritt verbindet der Analog-Multiplexer 13 nach entsprechender Ansteuerung durch die Steuer- und Auswerteschaltung 17 das dem Referenzwiderstand $R_2$ zugeordnete Leiterpaar 11 mit den Anschlüssen des Kondensators 19, um eine dritte Ladephase einzuleiten, in der der Kondensator 19 bis zum Erreichen des Gleichgewichtszustandes auf eine Ladespannung entsprechend dem Spannungsabfall an dem Referenzwiderstand $R_2$ geladen wird. Schließlich wird der Analog-Multiplexer erneut so angesteuert, daß er die Anschlüsse des Kondensators 19 mit den Ausgangsanschlüssen 21 und 23 verbindet, um eine erneute Entladephase des Kondensators 19 mit Erfassung der Entladezeit $t_2$ einzuleiten, wobei $t_2$ die Zeit vom Beginn der Entladephase bis zu dem Zeitpunkt bezeichnet, in dem die Kondensatorspannung die an dem Spannungsteiler 23 abgegriffene Referenzspannung des Komparators 27 unterschreitet.

Bei der Widerstandsmeßschaltung nach der Erfindung werden die Referenzwiderstände und die Meßwiderstände in der Reihenschaltung 3 vom gleichen Strom durchflossen, so daß ihre jeweiligen Spannungsabfälle also unabhängig vom Gesamtwiderstand der Reihenschaltung 3 und damit vom Gesamtstrom genau im Verhältnis ihrer Widerstandswerte stehen.

Der Wert Rx des Meßwiderstandes Rx hängt gemäß der nachstehenden Beziehung (1) von den gemessenen Entladezeiten tx, $t_1$, $t_2$ und von den Widerstandswerten $R_1$ und $R_2$ der Referenzwiderstände $R_1$,

$R_2$ ab:

$$Rx = R_1 \cdot \exp(\frac{tx\text{-}t_1}{t_2\text{-}t_1} \cdot \ln \frac{R_2}{R_1}) \qquad (1)$$

Die Steuer- und Auswerteschaltung 17 berechnet den Widerstandswert Rx nach einem programmierten Algorithmus auf der Basis der Beziehung (1) und stellt ihn in digitaler Form bereit.

Der beispielsweise als Transistor ausgebildete Schalter 5 in der Reihenschaltung 3 wird von der Steuer- und Auswerteschaltung 17 jeweils zu Beginn einer betreffenden Ladephase des Kondensators leitend geschaltet und mit Beginn einer jeweiligen Entladephase des Kondensators 19 in den hochohmigen Zustand versetzt. Während der Entladephasen fließt daher kein Strom durch die Reihenschaltung 3, wodurch der Stromverbrauch der gesamten Widerstandsmeßschaltung entsprechend reduziert wird.

Die Widerstandsmeßschaltung nach Fig. 1 kann beispielsweise als Temperaturmeßschaltung ausgebildet sein. In diesem Fall handelt es sich bei dem Meßwiderstand Rx um einen Temperaturmeßwiderstand, beispielsweise um einen Platinwiderstands-Temperaturfühler. Platinwiderstands-Temperaturfühler mit einem Temperaturkoeffizienten von etwa 0,39 %/K werden unter der Bezeichnung PT 100 mit einem Nennwiderstandswert von 100 Ω bei 0°C, PT 500 mit einem Nennwiderstandswert von 500 Ω bei 0°C und PT 1000 mit einem Nennwiderstandswert von 1000 Ω bei 0°C angeboten und zeichnen sich durch besonders gute Langzeitkonstanz und Reproduzierbarkeit aus.

In Fig. 1 weist der Meßwiderstand Rx vier Zuleitungen 50, 51, 52, 53 auf, über die er mit betreffenden Anschlußklemmen 46, 47, 48 und 49 einer die übrigen Bauteile der Widerstandsmeßschaltung 1 aufweisenden Platine (nicht gezeigt) verbunden ist. Die für den Spannungsabgriff vorgesehenen Zuleitungen 50 und 51 sind über die Anschlußklemmen 46 und 47 mit dem Leiterpaar 9 verbunden. Über die mit den Anschlußklemmen 48 und 49 verbundenen Zuleitungen 52 bzw. 53 ist der Meßwiderstand Rx in die Reihenschaltung 3 integriert. Diese Beschaltung entspricht einer Vierleiter-Meßkonfiguration, wie sie bei der konventionellen Widerstandsmessung eingesetzt wird, um den Einfluß der Zuleitungswiderstände auf das Meßergebnis zu minimieren.

Die Widerstandsmeßschaltung nach Fig. 1 ermöglicht jedoch ebenso die Messung bei Zweileiter-Konfiguration des Meßwiderstandes Rx, wobei die Anschlußklemmen 46 und 48 einerseits und die Anschlußklemmen 47 und 49 andererseits durch die bei 55 bzw. 56 angedeuteten Drahtbrücken kurzzuschließen sind und die Zuleitungen 50 und 51 entfallen können.

Gemäß einer Variante des in Fig. 1 gezeigten Ausführungsbeispiels ist die Möglichkeit der automatischen Erkennung der Anschlußkonfiguration des Meßwiderstands Rx und der Umschaltung zwischen Vierleiter-Meßbetrieb und Zweileiter-Meßbetrieb vorgesehen. Bei einer solchen Ausführungsform der Erfindung sind gemäß Fig. 1a die für den Spannungsabgriff bei Vierleiter-Meßbetrieb vorgesehenen Anschlußklemmen 46 und 47 mit dem Eingangsanschlußpaar 60 des Analog-Multiplexers 13 verbunden, wohingegen die Anschlußklemmen 48 und 49 mit einem gesonderten Eingangsanschlußpaar 58 des Analog-Multiplexers 13 verbunden sind. Zur Prüfung der Anschlußkonfiguration des Meßwiderstandes Rx steuert die Steuer- und Auswerteschaltung 17 den Multiplexer 13 in der Weise an, daß das Eingangsanschlußpaar 60 mit den Anschlüssen des Kondensators 19 verbunden wird. Im Falle der Vierleiter-Konfiguration des Meßwiderstandes Rx sind die gesonderten Spannungsabgriffszuleitungen 50, 51 vorhanden, und es findet die Aufladung des Kondensators 19 auf die dem Spannungsabfall am Meßwiderstand Rx entsprechende Ladespannung statt, so daß die Widerstandsmeßschaltung 1 im Vierleiter-Meßbetrieb arbeiten kann.

Liegt Zweileiteranschlußkonfiguration des Meßwiderstandes Rx vor, so fehlen die Spannungsabgriffszuleitungen 50 und 51. Bei Verbindung der Eingangsanschlüsse 60 des Analog-Multiplexers mit den Anschlüssen des Kondensators 19 kommt es folglich nicht zur Aufladung des Kondensators 19, was von der Steuerund Auswerteschaltung 17 daran festgestellt werden kann, daß in der nachfolgend eingeleiteten "Entladephase" kein Zählvorgang des Zählers 41 ausgelöst wird, da die Kondensatorspannung am Eingang 25 des Komparators 27 die Referenzspannung am Eingang 29 des Komparators 27 nicht überschreitet. Die Steuerund Auswerteschaltung kann in diesem Fall vom Vierleiter-Meßbetrieb auf den Zweileiter-Meßbetrieb umschalten, wobei zum Abgriff des Spannungsabfalls an dem Meßwiderstand Rx das Eingangsanschlußpaar 58 des Analog-Multiplexers 13 in den jeweiligen Meßzyklen mit dem Kondensator 19 verbunden wird, um die Ladephase für die nachfolgende Bestimmung der Entladezeit tx einzuleiten.

Für den Fall, daß es sich bei dem Meßwiderstand Rx um einen PT 100-Platinwiderstands-Temperaturfühler handelt und der Widerstandsmeßbereich zwischen 100 und 170 Ω liegen soll, wird als Beispiel folgender Dimensionierungsvorschlag für die Widerstandsmeßschaltung gemacht:

Rx: 100 .... 170 Ω
$R_1$: 100 Ω
$R_2$: 170 Ω
$R_E$: 500 kΩ
Kapazität C des Kondensators 19: 33 nF
Frequenz des Taktimpulssignals für den Zähler 41: 1 MHz
Referenzspannung am Eingang 29 des Komparators 27: $U_B/6$, wobei $U_B$ die Spannung der Batterie 7 von beispielsweise 3V bezeichnet.

Der Widerstandswert des Referenzwiderstandes $R_1$ liegt in der Nähe des kleinsten Meßbereichsendwertes des Meßwiderstandes Rx, wohingegen der Widerstandswert des Widerstandes $R_2$ in der Nähe des größten Meßbereichsendwertes des Meßwiderstandes Rx liegt. Eine derartige Dimensionierung der Referenzwiderstände $R_1$ und $R_2$ wird zur Erzielung einer optimalen Genauigkeit bei der Ermittlung des Widerstandswertes Rx vorgeschlagen.

Bei dem Ausführungsbeispiel nach Fig. 1 ist lediglich ein Meßwiderstand Rx in der Reihenschaltung 3 vorgesehen. Bei der erfindungsgemäßen Widerstandsmeßschaltung können jedoch auch mehrere Meßwiderstände Rx in der Reihenschaltung 3 vorgesehen sein und zur Bestimmung ihrer einzelnen Widerstandswerte in den Meßprozeß einbezogen werden. Ein entsprechendes Ausführungsbeispiel zeigt Fig. 2. Elemente in Fig. 2, die Elementen der Schaltung nach Fig. 1 entsprechen, sind mit jeweils gleichen Bezugsziffern gekennzeichnet, so daß zur Erläuterung ihrer Funktion auf die Beschreibung des Ausführungsbeispiels nach Fig. 1 verwiesen werden kann. Die weitere Beschreibung des Ausführungsbeispiels nach Fig. 2 beschränkt sich im wesentlichen auf Unterschiede zum Ausführungsbeispiel nach Fig. 1.

Die Widerstandsmeßschaltung nach Fig. 2 weist zwei Meßwiderstände $Rx_1$ und $Rx_2$ in Reihe zueinander und in Reihe zu einer Parallelschaltung aus zwei Referenzwiderstandsketten 3a und 3b auf, wobei der Stromfluß durch die Referenzwiderstandsketten 3a und 3b jeweils gesondert mittels der Schalter 5a bzw. 5b unterbrochen werden kann, was unter Kontrolle der Steuer- und Auswerteschaltung 17 erfolgt.

Bei den Meßwiderständen $Rx_1$ und $Rx_2$ handelt es sich im Beispielsfall um Platinwidestands-Temperaturfühler insbesondere gleichen Typs (z. B. PT 100 oder PT 500), so daß die Widerstandsmeßschaltung nach Fig. 2 zur Messung von Temperaturdifferenzen mit hoher relativer Genauigkeit der Meßwerte einsetzbar ist. Ein Anwendungsbeispiel wäre die Erfassung der Temperaturdifferenz zwischen der Vorlauftemperatur und der Rücklauftemperatur einer Heizung, wobei einer der Meßwiderstände $Rx_1$, $Rx_2$ thermisch mit dem Vorlauf zu koppeln ist und der andere Meßwiderstand thermisch mit dem Rücklauf zu koppeln ist. Die Schaltung nach Fig. 2 kann mit einer den Volumenstrom des die Heizung durchströmenden Wassers messenden Durchflußmeßeinrichtung zu einem Wärmemengenzähler kombiniert werden, der den thermischen Verbrauch der Heizung aus dem Wasser-Volumenstrom und der Temperaturdifferenz zwischen Vorlauf und Rücklauf bestimmt.

Die Referenzwiderstandsketten 3a und 3b sind unterschiedlichen Meßwiderstandstypen zugeordnet. Die Widerstände $R_{1a}$ und $R_{2a}$ der Referenzwiderstandskette 3a sind im Hinblick auf optimale Genauigkeit der Temperaturmessung mit einem PT 100-Platinwiderstands-Temperaturfühler dimensioniert, wohingegen die Widerstände $R_{1b}$ und $R_{2b}$ der Referenzwiderstandskette 3b im Hinblick auf optimale Genauigkeit bei der Temperaturmessung mit einem PT 500-Platinwiderstands-Temperaturfühler dimensioniert sind. Handelt es sich bei den beiden Meßwiderständen $Rx_1$ und $Rx_2$ um Platinwiderstands-Temperaturfühler gleichen Typs, so kommt bei der Widerstands- bzw. Temperaturmessung jeweils nur die entsprechend zugeordnete Referenzwiderstandskette 3a oder 3b zum Einsatz, wobei der Stromfluß durch die jeweilige andere Referenzwiderstandskette dadurch unterbrochen wird, daß der zugehörige Schalter 5a bzw. 5b in den hochohmigen Zustand geschaltet wird.

Für die folgenden Betrachtungen sei der Einfachheit halber angenommen, daß es sich bei den Meßwiderständen $Rx_1$ und $Rx_2$ um PT 100-Temperaturfühler handelt. In diesem Fall ist der Schalter 5b unter Kontrolle der Steuer- und Auswerteschaltung 17 in den hochohmigen Zustand geschaltet, so daß die an dem Meßzyklus teilnehmende Reihenschaltung 3 aus den Widerständen $Rx_1$, $Rx_2$, $R_{2a}$ und $R_{1a}$ besteht.

Ein Meßzyklus läuft analog zu den betreffenden Erläuterungen zu dem Ausführungsbeispiel nach Fig. 1 so ab, daß der Analog-Multiplexer 13 die Leiterpaare 8, 9, 10a und 11a unter Kontrolle durch die Steuer- und Auswerteschaltung 17 nacheinander mit den Anschlüssen des Kondensators 19 verbindet, um den Kondensator 19 jeweils bis Erreichen des Gleichgewichtszustandes auf die einzelnen Ladespannungen entsprechend den Spannungsabfällen an den Widerständen $Rx_1$, $Rx_2$, $R_{1a}$ und an dem in Reihe zusammengefaßten Widerstandspaar $R_{1a}$, $R_{2a}$ aufzuladen, wobei jeder Ladephase des Kondensators 19 eine Entladephase folgt, in der die Entladezeit vom Beginn der jeweiligen Entladephase bis zu dem Zeitpunkt gemessen wird, in dem die Kondensatorspannung die Referenzspannung am Eingang 29 des Komparators 27 unterschreitet. Die Messung der Entladezeiten $tx_1$, $tx_2$, $t_{1a}$ und $t_{1a2a}$ erfolgt in gleicher Weise wie die Entladezeitmessung bei dem ersten Ausführungsbeispiel gemäß Fig. 1.

Die Widerstandswerte $Rx_1$ und $Rx_2$ der Meßwiderstände $Rx_1$ und $Rx_2$ hängen gemäß den nachstehenden Beziehungen 2 bzw. 3 von den betreffenden Entladezeiten des Kondensators und von den Werten der Referenzwiderstände $R_{1a}$ und $R_{2a}$ ab.

$$Rx_1 = R_{1a} \cdot \exp\left(\frac{tx_1 - t_{1a}}{t_{1a2a} - t_{1a}} \cdot \ln \frac{R_{1a} + R_{2a}}{R_{1a}}\right) \qquad (2)$$

$$Rx_2 = R_{1a} \cdot \exp\left(\frac{tx_2 - t_{1a}}{t_{1a2a} - t_{1a}} \cdot \ln \frac{R_{1a} + R_{2a}}{R_{1a}}\right) \qquad (3)$$

Darin bezeichnet

$tx_1$ die Entladezeit bei der Entladung aus dem Ladezustand mit einer Ladespannung entsprechend dem Spannungsabfall über dem Meßwiderstand $Rx_1$,

$tx_2$ die Entladezeit des Kondensators 19 bei der Entladung aus dem Ladezustand mit der Ladespannung entsprechend dem Spannungsabfall an dem Meßwiderstand $Rx_2$,

$t_{1a}$ die Entladezeit bei der Entladung des Kondensators 19 aus dem Ladezustand mit der Ladespannung entsprechend dem Spannungsabfall an dem Referenzwiderstand $R_{1a}$,

$t_{1a2a}$ die Entladezeit bei der Entladung des Kondensators 19 aus dem Ladezustand mit der Ladespannung entsprechend dem Spannungsabfall an den beiden Referenzwiderständen $R_{1a}$ und $R_{2a}$,

$R_{1a}$ den Wert des Widerstandes $R_{1a}$ und

$R_{2a}$ den Wert des Widerstandes $R_{2a}$.

Die Steuer- und Auswerteschaltung 17 berechnet die Widerstandswerte $Rx_1$ und $Rx_2$ nach einem Algorithmus, auf der Basis der obigen Beziehungen (2) bzw. (3).

Die Steuer- und Auswerteschaltung 17 ist ferner dazu eingerichtet, das Verhältnis der Widerstandswerte $Rx_1$ und $Rx_2$ nach folgender Beziehung (4) zu berechnen:

$$\frac{Rx_1}{Rx_2} = \exp\left(\frac{tx_1 - tx_2}{t_{1a2a} - t_{1a}} \cdot \ln \frac{R_{1a} + R_{2a}}{R_{1a}}\right) \qquad (4)$$

Im Sinne des Anspruchs 1 stellt bei der in Fig. 2 gezeigten Schaltung der Referenzwiderstand $R_{1a}$ eine erste Widerstandseinheit und die Reihenschaltung aus den beiden Widerständen $R_{1a}$ und $R_{2a}$ eine zweite Referenzwiderstandseinheit dar.

Angenommen, der Widerstandsmeßbereich der PT 100-Temperaturmeßfühler $Rx_1$, $Rx_2$ sei auf 100 $\Omega$ bis 170 $\Omega$ festgelegt, dann wird vorgeschlagen, $R_{1a}$ mit 100 $\Omega$ und $R_{2a}$ mit 70 $\Omega$ zu dimensionieren, so daß der Widerstandswert von $R_{1a}$ in der Nähe des unteren Meßbereichsendwertes - und die Summe der Widerstandswerte von $R_{1a}$ und $R_{2a}$ in der Nähe des oberen Meßbereichsendwerts liegt. Durch eine derartige Dimensionierung der Referenzwiderstände können der Einfluß etwaiger Temperaturabhängigkeiten der Referenzwiderstände und der Einfluß der Absolutgenauigkeit der Referenzwiderstände auf die Meßgenauigkeit bei der Widerstandsmessung von $Rx_1$ und $Rx_2$ äußerst gering gehalten werden. Denkbar ist eine noch weitere Unterteilung der Referenzwiderstände mit entsprechender Auswahl von Paaren von Referenzwiderstandskombinationen nach Maßgabe des tatsächlich genutzten Meßbereiches der PT 100-Temperaturmeßfühler.

Handelt es sich bei den Meßwiderständen $Rx_1$ und $Rx_2$ um PT 500-Platinwiderstands-Temperaturfühler, so übernehmen die Referenzwiderstände $R_{1b}$ und $R_{2b}$ die vorstehend beschriebene Rolle der Referenzwiderstände $R_{1a}$ und $R_{2a}$, wobei der Referenzwiderstandszweig 3a durch entsprechende Ansteuerung des Schalters 5a ausgeschaltet ist. Welche der beiden Referenzwiderstandsketten 3a oder 3b zum Einsatz kommt, kann durch entsprechende Programmierung der Steuer- und Auswerteschaltung 17 bestimmt werden. Andererseits kann die Steuer- und Auswerteschaltung 17 dazu eingerichtet sein, automatisch zu erfassen, welcher Typ von Platinwiderstands-Temperaturfühler angeschlossen ist, um dann die zugeordnete Referenzwiderstandskette 3a oder 3b durch entsprechende Steuerung der Schalter 5a und 5b für die Messung auszuwählen.

Bei der Schaltung nach Fig. 2 ist noch auf einen zusätzlichen Entladepfad für den Kondensator 19 hinzuweisen, wobei dieser zusätzliche Entladepfad einen weiteren Entladewiderstand $R_{E1}$ in Parallelschaltung zu dem Entladewiderstand $R_E$ aufweist. Der zusätzliche Entladepfad kann durch Steuerung des Schalters 47 wahlweise aktiv oder inaktiv geschaltet werden, um die Entladezeitkonstante für die jeweilige Entladung des Kondensators 19 zu ändern. Durch Zuschaltung des Entladewiderstandes $R_{E1}$ wird die Entlade-Zeitkonstante herabgesetzt, wodurch die betreffenden Entladephasen verkürzt werden. Die Zuschaltung des zusätzlichen Entladewiderstandes $R_{E1}$ zur Verkürzung der Entladephasen und somit zur Absenkung des Strombedarfes im Zeitmeßkreis 27, 41 kommt in den Fällen in Frage, in denen eine geringfügige Verminderung der Auflösung der Widerstandsmeßergebnisse in Kauf genommen werden kann.

Sind besonders hohe Anforderungen an die Genauigkeit der Absolutwerte bzw. der Differenzwerte bei der Widerstandsmessung gestellt, so besteht die Möglichkeit, die Widerstandsmeßschaltung nach der Erfindung zu kalibrieren, in dem Sinne, daß Kalibriermessungen mit Normwiderständen hoher Präzision durchgeführt werden, die bei diesen Kalibriermessungen die Rolle der Meßwiderstände übernehmen. Die bei solchen Kalibriermessungen erhaltenen Meßergebnisse können dann ggf. dazu herangezogen werden, Korrekturfaktoren oder Korrekturfunktionen abzuleiten, die in einem Speicher der Steuer- und Auswerteschaltung 17 gespeichert werden können und von der Steuer- und Auswerteschaltung 17 in die Auswertung der Meßergebnisse späterer Messungen mit betreffenden Meßwiderständen einbezogen werden.

Eine solche Kalibrierung kann für einen bestimmten Schaltungsaufbautyp mit gegebenen Bauelementen und gegebenem Schaltungslayout - oder gar für jedes Schaltungsindividuum vorgenommen werden.

**Patentansprüche**

1. Widerstandsmeßschaltung,

   - mit einer an Gleichspannung einer Gleichspannungsquelle (7) anzuschließenden Reihenschaltung (3) aus wenigstens zwei Referenzwiderstandseinheiten ($R_1$, $R_2$; $R_{1a}$, $R_{1a}+R_{2a}$) und wenigstens einem Meßwiderstand (Rx; $Rx_1$, $Rx_2$),
   - wobei jede der Referenzwiderstandseinheiten und jeder Meßwiderstand über ein jeweiliges von der Reihenschaltung (3) abzweigendes Leiterpaar (9, 10, 11; 8, 9, 10a, 11a) mit einer Analog-Multiplexerschaltung (13) elektrisch verbunden ist, die unter Kontrolle einer Steuer- und Auswerteschaltung (17)

     a) wechselweise jedes der Leiterpaare (9, 10, 11; 8, 9, 10a, 11a) mit einem Kondensator (19) elektrisch verbindet, um den Kondensator (19) jeweils bis zum Erreichen des Gleichgewichts-Ladezustandes auf eine den Spannungsabfall an der betreffenden Referenzwiderstandseinheit ($R_1$, $R_2$; $R_{1a}$, $R_{1a}+R_{2a}$) bzw. an dem betreffenden Meßwiderstand (Rx; $Rx_1$, $Rx_2$) repräsentierende Ladespannung aufzuladen, und

     b) die nach jeweiliger Aufladung des Kondensators (19) den Kondensator von dem betreffenden Leiterpaar (9, 10, 11; 8, 9, 10a, 11a) elektrisch trennt und mit einer einen Entladewiderstand ($R_E$) enthaltenden Kondensatorentladeschaltung verbindet, um den Kondensator (19) über den Entladewiderstand ($R_E$) zu entladen,

   - wobei die Kondensatorentladeschaltung mit einer digitalen Zeitmeßschaltung (41, 43) verbunden ist, die die Entladezeit vom Beginn der jeweiligen Entladephase bis zum Abfall der Kondensatorspannung auf einen vorbestimmten Wert erfaßt und als digitale Information zur Speicherung und weiteren Auswertung durch die Steuer- und Auswerteschaltung (17) bereitstellt, und
   - wobei die Steuer- und Auswerteschaltung (17) auf der Basis wenigstens dreier Entladezeitmeßwerte, die den Entladungen des Kondensators (19) aus den Ladezuständen entsprechend den jeweiligen Spannungsabfällen an den einzelnen Referenzwiderstandseinheiten ($R_1$, $R_2$; $R_{1a}$, $R_{1a}+R_{2a}$) und an einem betreffenden Meßwiderstand (Rx; $Rx_1$, $Rx_2$) zugeordnet sind, ein den Widerstandswert des betreffenden Meßwiderstandes (Rx; $Rx_1$, $Rx_2$) repräsentierendes oder ggf. von dem Widerstandswert abhängiges Meßergebnis berechnet.

2.  Widerstandsmeßschaltung nach Anspruch 1, wobei die Reihenschaltung (3) aus den Referenzwiderstandseinheiten und dem Meßwiderstand bzw. den Meßwiderständen ferner einen elektronischen Schalter (5) enthält, der von der Steuerund Auswerteschaltung (17) derart gesteuert ist, daß er den Stromfluß durch die Reihenschaltung (3) während der Entladephasen des Kondensators (19) unterbricht.

3.  Widerstandsmeßschaltung nach Anspruch 1 oder 2, wobei ein mit dem Entladewiderstand (R_E) verbundener Komparator (27) vorgesehen ist, der die Kondensatorspannung mit einer dem vorbestimmten Wert entsprechenden Referenzspannung vergleicht und der ein Stoppsignal an die Zeitmeßschaltung (41, 43) abgibt, wenn die Kondensatorspannung den vorbestimmten Wert unterschreitet, und wobei die Zeitmeßschaltung (41, 43) einen Taktimpulse einer Taktimpulsquelle (43) zählenden Zähler (41) aufweist, dessen Zählbetrieb durch ein Startsignal synchron mit Beginn einer jeweiligen Kondensatorentladephase gestartet - und durch das Stoppsignal des Komparators (27) gestoppt wird, so daß das jeweilige Zählergebnis des Zählers (41) einen auf die Periodendauer des Taktimpulssignals der Taktimpulsquelle (43) normierten Entladezeitmeßwert repräsentiert.

4.  Widerstandsmeßschaltung nach Anspruch 3, wobei einer der Anschlüsse des Kondensators (19) während der Entladephasen unmittelbar an Massepotential liegt und der andere Anschluß des Kondensators mit einem ersten Eingang des Komparators (27) - und ferner über den Entladewiderstand (R_E) mit Massepotential verbunden ist.

5.  Widerstandsmeßschaltung nach Anspruch 3 oder 4, wobei zur Bereitstellung der Referenzspannung des Komparators (27) ein Spannungsteiler (33) vorgesehen ist, der parallel zu der Reihenschaltung (3) aus den Referenzwiderständen und dem Meßwiderstand bzw. den Meßwiderständen an der Gleichspannungsquelle (7) angeschlossen ist und dessen Spannungsteilerabgriffspunkt (31) mit einem zweiten Eingang des Komparators (27) verbunden ist.

6.  Widerstandsmeßschaltung nach einem der vorhergehenden Ansprüche, wobei die Steuer- und Auswerteschaltung (17) einen Mikroprozessor enthält.

7.  Widerstandsmeßschaltung nach Anspruch 6, wobei die Zeitmeßschaltung (41, 43) einen in dem Mikroprozessor integrierten Timer umfaßt.

8.  Widerstandsmeßschaltung nach einem der vorhergehenden Ansprüche, wobei die Referenzwiderstandseinheiten (R_1, R_2) jeweils aus einem Einzelwiderstand bestehen.

9.  Widerstandsmeßschaltung nach einem der Ansprüche 1 - 7, wobei wenigstens eine der Referenzwiderstandseinheiten aus mehreren Einzelwiderständen (R_{1a}, R_{2a}) besteht.

10. Widerstandsmeßschaltung nach einem der vorhergehenden Ansprüche als Temperaturmeßschaltung, wobei der Meßwiderstand (Rx) ein Temperaturmeßwiderstand, insbesondere Platin-Temperaturmeßfühler ist.

11. Widerstandsmeßverfahren,

    -   bei dem eine Gleichspannung an eine Reihenschaltung aus einem Meßwiderstand und wenigstens zwei Referenzwiderständen angelegt wird,
    -   bei dem ferner der Meßwiderstand und die beiden Referenzwiderstände nacheinander mit einem Kondensator verbunden werden, um den Kondensator bis zum Erreichen des Gleichgewichtsladezustandes auf eine dem Spannungsabfall an dem jeweiligen Referenzwiderstand bzw. an dem Meßwiderstand entsprechende Ladespannung aufzuladen, wobei der Kondensator jeweils nach einer betreffenden Aufladung wieder entladen - und dabei die Entladezeit vom Beginn der Entladung bis zu dem Zeitpunkt gemessen wird, in dem die Kondensatorspannung einen vorbestimmten Spannungswert unterschreitet,
    -   und wobei der Widerstandswert des Meßwiderstandes auf der Basis der nachstehenden Beziehung (1) bestimmt wird:

$$Rx = R_1 \cdot \exp\left(\frac{tx\text{-}t_1}{t_2\text{-}t_1} \cdot \ln \frac{R_2}{R_1}\right) \qquad (1),$$

    worin

    Rx      den Widerstandswert des Meßwiderstandes,
    R_1, R_2   die Widerstandswerte der beiden Referenzwiderstände,
    tx      die gemessene Entladezeit bei Entladung des Kondensators aus dem Ladezustand mit der Ladespannung entsprechend dem Spannungsabfall an dem Meßwiderstand,
    t_1     die gemessene Entladezeit bei Entladung des Kondensators aus dem Ladezustand mit der Ladespannung entsprechend dem Spannungsabfall an dem Referenzwiderstand mit dem Widerstandswert $R_1$,

$t_2$    die gemessene Entladezeit bei Entladung des Kondensators aus dem Ladezustand mit der Ladespannung entsprechend dem Spannungsabfall an dem Referenzwiderstand mit dem Widerstandswert $R_2$

bezeichnet.

## Claims

1. Resistance measuring circuit,

    - comprising a series circuit (3) consisting of at least two reference resistance units ($R_1$, $R_2$; $R_{1a}$, $R_{1a}$, + $R_{2a}$) and at least one measuring resistor (Rx; $Rx_1$, $Rx_2$) which are to be connected to the direct voltage of a direct voltage source (7),

    - wherein each of the reference resistance units and each measuring resistor is electrically connected via a respective pair of conductors (9, 10, 11; 8, 9, 10a, 11a) branching from the series circuit (3) to an analogue multiplexer circuit (13), which, under the control of a control and evaluation circuit (17),

        a) alternately electrically connects each of the pairs of conductors (9, 10, 11; 8, 9, 10a, 11a) to a capacitor (19) in order to charge the capacitor (19) to a charging voltage representing the voltage drop at the relevant reference resistance unit ($R_1$, $R_2$; $R_{1a}$, $R_{1a}$ + $R_{2a}$) and at the relevant measuring resistor (Rx; $Rx_1$, $Rx_2$) until the equilibrium charging state is reached respectively, and

        b) electrically disconnects the capacitor from the relevant pair of conductors (9, 10, 11; 8, 9, 10a, 11a) after respective charging of the capacitor (19) and connects it to a capacitor discharge circuit containing a discharge resistor ($R_E$) in order to discharge the capacitor (19) via the discharge resistor ($R_E$),

    - wherein the capacitor discharge circuit is connected to a digital time measuring circuit (41, 43) which detects the discharge time from the start of the respective discharge phase until the drop in the capacitor voltage to a predetermined value and provides this as digital information for storage and further evaluation by the control and evaluation circuit (17), and

    - wherein the control and evaluation circuit (17) calculates a measuring result representing the resistance value of the relevant measuring resistor (Rx; $Rx_1$, $Rx_2$) or optionally dependent on the resistance value, on the basis of at least three discharge time measured values associated with the discharges of the capacitor (19) from the loading states in accordance with the respective voltage drops at the individual reference resistance units ($R_1$, $R_2$; $R_{1a}$, $R_{1a}$ + $R_{2a}$) and at a relevant measuring resistor (Rx; $Rx_1$, $Rx_2$).

2. Resistance measuring circuit according to claim 1, wherein the series circuit (3) consisting of the reference resistance units and the measuring resistance or measuring resistances also contains an electronic switch (5) controlled by the control and evaluation circuit (17) in such a way that it interrupts the current flow through the series circuit (3) during the discharge phases of the capacitor (19).

3. Resistance measuring circuit according to claim 1 or 2, wherein a comparator (27) connected to the discharge resistor ($R_E$) is provided, which compares the capacitor voltage with a reference voltage corresponding to the predetermined value and supplies a stop signal to the time measuring circuit (41, 43) if the capacitor voltage falls below the predetermined value, and wherein the time measuring circuit (41, 43) has a counter (41) counting clock pulses of a clock pulse source (43), the counting operation of which counter begins synchronously with the start of a respective capacitor discharge phase owing to a start signal and is stopped by the stop signal of the comparator (27), so the respective counting result of the counter (41) represents a discharge time measured value standardised to the period of the clock pulse signal of the clock pulse source (43).

4. Resistance measuring circuit according to claim 3, wherein one of the terminals of the capacitor (19) is directly connected to earth potential during the discharge phases and the other capacitor terminal is connected to a first input of the comparator (27) and also via the discharge resistor ($R_E$) to earth potential.

5. Resistance measuring circuit according to claim 3 or 4, wherein to provide the reference voltage of the comparator (27) a voltage divider (33) is provided which is connected in parallel with the series circuit (3) consisting of the reference resistors and the measuring resistor(s) to the direct voltage source (7) and the voltage divider tapping point (31) of which is connected to a second input of the comparator (27).

6. Resistance measuring circuit according to any of the preceding claims, wherein the control and evaluation circuit (17) contains a microprocessor.

7. Resistance measuring circuit according to claim 6, wherein the time measuring circuit (41, 43) comprises a timer integrated in the microprocessor.

8. Resistance measuring circuit according to any of the preceding claims, wherein the reference resistance units ($R_1$, $R_2$) each consist of an individual resistor.

9. Resistance measuring circuit according to any of claims 1 to 7, wherein at least one of the reference resistance units consists of a plurality of individual resistors ($R_{1a}$, $R_{2a}$).

10. Resistance measuring circuit according to any of the preceding claims as a temperature measuring circuit, wherein the measuring resistor (Rx) is a temperature measuring resistor, in particular platinum temperature sensor.

11. Resistance measuring method,

    - wherein a direct voltage is applied to a series circuit consisting of a measuring resistor and at least two reference resistors,

    - wherein the measuring resistor and the two reference resistors are also connected in series to a capacitor in order to charge the capacitor to a charging voltage corresponding to the voltage drop at the respective reference resistor or at the measuring resistor until the equilibrium charging state is reached, wherein after appropriate charging in each case, the capacitor is again discharged and in the process the discharge time is measured from the start of discharging until the instant at which the capacitor voltage falls below a predetermined voltage value,

    - and wherein the resistance value of the measuring resistor is determined on the basis of the following equation (1):

$$Rx = R_1 \cdot \exp\left(\frac{tx\text{-}t_1}{t_2\text{-}t_1} \cdot \ln \frac{R_2}{R_1}\right) \qquad (1),$$

    in which

        Rx represents the resistance value of the measuring resistor,

        $R_1$, $R_2$ represents the resistance values of the two reference resistors,

tx represents the measured discharge time on- discharging of the capacitor from the charged state with the charging voltage in accordance with the voltage drop at the measuring resistor,

$t_1$ represents the measured discharge time on discharging the capacitor from the charging state with the charging voltage in accordance with the voltage drop at the reference resisistor with the resistance value $R_1$,

$t_2$ represents the measured discharge time on discharging the capacitor from the charging state with the charging voltage in accordance with the voltage drop at the reference resistor with the resistance value $R_2$.

## Revendications

1. Circuit de mesure de résistance,

    - comportant un circuit en série (3), à raccorder à la tension continue d'une source de tension continue (7), constitué d'au moins deux unités de résistances de référence ($R_1$, $R_2$ ; $R_{1a}$, $R_{1a}$ + $R_{2a}$) et d'au moins une résistance de mesure (Rx ; $Rx_1$, $Rx_2$),

    - dans lequel chacune des unités de résistances de référence et chaque résistance de mesure sont reliées électriquement, par une paire de conducteurs (9, 10, 11 ; 8, 9, 10a, 11a) respective, partant du circuit en série (3), à un circuit multiplexeur analogique (13) qui, sous le contrôle d'un circuit de commande et d'exploitation (17),

        a) relie électriquement alternativement chacune des paires de conducteurs (9, 10, 11 ; 8, 9, 10a, 11a) à un condensateur (19), afin de charger le condensateur (19) jusqu'à ce que soit atteint dans chaque cas l'état de charge d'équilibre sur une tension de charge représentant la chute de tension sur l'unité de résistance de référence ($R_1$, $R_2$ ; $R_{1a}$, $R_{1a}$ + $R_{2a}$) concernée ou sur la résistance de mesure (Rx ; $Rx_1$, $Rx_2$) concernée, et

        b) sépare électriquement, après chaque charge du condensateur (19), le condensateur de la paire de conducteurs (9, 10, 11 ; 8, 9, 10a, 11a) concernée, et le relie à un circuit de décharge de condensateur contenant une résistance de décharge ($R_E$), afin de décharger le condensateur (19) à travers la résistance de décharge ($R_E$),

- dans lequel le circuit de décharge du condensateur est relié à un circuit numérique de mesure du temps (41, 43) qui détecte le temps de décharge du début de chaque phase de décharge jusqu'à la chute de la tension du condensateur à une valeur prédéterminée, et le traite comme information numérique en vue de sa mémorisation et d'une exploitation ultérieure par le circuit de commande et d'exploitation (17), et

- dans lequel le circuit de commande et d'exploitation (17) calcule, sur la base d'au moins trois valeurs de mesure du temps de décharge, qui sont associées aux décharges du condensateur (19) à partir des états de charge correspondant aux chutes respectives de la tension sur les différentes unités de résistances de référence ($R_1$, $R_2$ ; $R_{1a}$, $R_{1a} + R_{2a}$) et sur une résistance de mesure (Rx ; $Rx_1$, $Rx_2$) concernée, un résultat de mesure représentant la valeur de la résistance de mesure concernée (Rx ; $Rx_1$, $Rx_2$), ou dépendant éventuellement de la valeur de la résistance.

2. Circuit de mesure de résistance selon la revendication 1, dans lequel le circuit en série (3) constitué des unités de résistance de référence et de la résistance de mesure ou des résistances de mesure, contient en outre un interrupteur électronique (5) qui est commandé par le circuit de commande et d'exploitation (17) de manière à interrompre la circulation du courant à travers le circuit série (3) pendant les phases de décharge du condensateur (19).

3. Circuit de mesure de résistance selon la revendication 1 ou 2, dans lequel est prévu un comparateur (27), relié à la résistance de charge ($R_E$), qui compare la tension du condensateur à une tension de référence correspondant à la valeur prédéterminée, et qui délivre un signal d'arrêt au circuit de mesure du temps (41, 43), lorsque la tension du condensateur passe au-dessous de la valeur prédéterminée, et dans lequel le circuit de mesure du temps (41, 43) comporte un compteur (41) comptant des impulsions de rythme d'une source d'impulsions de rythme (43) dont le mode de comptage est démarré par un signal de démarrage de manière synchrone avec le début de chaque phase de décharge du condensateur - et est arrêté par le signal de stop du comparateur (27), de sorte que chaque résultat de comptage du compteur (41) représente une valeur du temps de décharge normalisée sur la durée de la période du signal d'impulsions de rythme de la source d'impulsions de rythme (43).

4. Circuit de mesure de résistance selon la revendication 3, dans lequel l'une des bornes du condensateur (19) est reliée directement au potentiel de masse pendant les phases de décharge, et l'autre borne du condensateur est reliée à une première entrée du comparateur (17) - et en outre par la résistance de décharge ($R_E$), au potentiel de masse.

5. Circuit de mesure de résistance selon la revendication 3 ou 4, dans lequel pour produire la tension de référence du comparateur (27), il est prévu un diviseur de tension (33) qui est raccordé, en parallèle au circuit série (3) constitué des résistances de référence et de la résistance de mesure ou des résistances de mesure, à la source de tension continue (7), et dont le point de prise (31) du diviseur de tension est relié à la deuxième entrée du comparateur (27).

6. Circuit de mesure de résistance selon l'une des revendications précédentes, dans lequel le circuit de commande et d'exploitation (17) contient un microprocesseur.

7. Circuit de mesure de résistance selon la revendication 6, dans lequel le circuit de mesure du temps (41, 43) comprend une minuterie intégrée au microprocesseur.

8. Circuit de mesure de résistance selon l'une des revendications précédentes, dans lequel les unités de résistance de référence ($R_1$, $R_2$) sont constituées chacune d'une résistance individuelle.

9. Circuit de mesure de résistance selon l'une des revendications 1 à 7, dans lequel au moins l'une des unités de résistance de référence est constituée de plusieurs résistances individuelles ($R_{1a}$, $R_{2a}$).

10. Circuit de mesure de résistance selon l'une des revendications précédentes, constituant un circuit de mesure de la température, dans lequel la résistance de mesure (Rx) est une résistance de mesure de la température, en particulier une sonde de mesure de la température à platine.

11. Procédé de mesure de résistance

- dans lequel une tension continue est appliquée à un circuit série constitué d'une résistance de mesure et d'au moins deux résistances de référence,

- dans lequel en outre la résistance de mesure et les deux résistances de référence sont reliées successivement à un condensateur, pour charger le condensateur jusqu'à ce que soit atteint l'état de charge d'équilibre sur une tension de charge correspondant à la chute de tension sur la résistance de référence respective ou sur la résistance de mesure, le condensateur étant à nouveau déchargé après une charge correspondante - et ce faisant, le temps de décharge est mesuré depuis le début de la décharge jusqu'à l'instant auquel la tension du condensateur passe au-dessous d'une valeur de tension déterminée,

- et dans lequel la valeur de la résistance de mesure est déterminée sur la base de la relation (1) suivante :

$$Rx = R_1 \cdot \exp\left(\frac{tx\text{-}t_1}{t_2\text{-}t_1} \cdot \ln \frac{R_2}{R_1}\right) \qquad (1),$$

dans laquelle

$R_x$ désigne la valeur de la résistance de mesure,

$R_1$, $R_2$ les valeurs des deux résistances de référence,

tx le temps de décharge mesuré pendant la décharge du condensateur depuis l'état de charge à la tension de charge correspondant à la chute de tension sur la résistance de mesure,

$t_1$ le temps de décharge mesuré pendant la décharge du condensateur depuis l'état de charge à la tension de charge correspondant à la chute de tension sur la résistance de référence de valeur $R_1$,

$t_2$ le temps de décharge mesuré pendant la décharge du condensateur à partir de l'état de charge à la tension de charge correspondant à la chute de tension sur la résistance de référence de valeur $R_2$.

Fig. 1

Fig. 1a

_Fig.2_

_Fig. 3_